# EUROPÄISCHE PATENTSCHRIFT

(11) **EP 1 816 676 B1**
(45) Veröffentlichungstag und Bekanntmachung des Hinweises auf die Patenterteilung: **30.07.2008**
(21) Anmeldenummer: 07002025.0
(22) Anmeldetag: 31.01.2007
(51) Int. Cl.: H01L 23/043

(54) **Leistungshalbleitermodul**
High performance semiconductor module
Module semi-conducteur de puissance

(30) Priorität: 07.02.2006 DE 102006005445
(43) Veröffentlichungstag der Anmeldung: 08.08.2007
(73) Patentinhaber: SEMIKRON Elektronik GmbH & Co. KG, 90431 Nürnberg (DE)
(72) Erfinder: Brucchi, Fabio, 00189 Rome (IT)

(56) Entgegenhaltungen:
- EP-A2- 0 205 746
- US-A1- 2002 020 916
- ANONYMOUS: "SEMITOP 3, SK40DH" INTERNET ARTICLE, [Online] 2004, XP002432753 Gefunden im Internet: URL:www.semikron.com> [gefunden am 2007-05-08]

## Beschreibung

Die Erfindung betrifft ein Leistungshalbleitermodul, mit einem plättchenförmigen Substrat, das auf einer ersten Hauptfläche eine wärmeableitende Schicht aufweist und das auf der gegenüberliegenden zweiten Hauptfläche mit einer Leiterbahnstruktur ausgebildet ist, an der Leistungshalbleiterbauelemente und Anschlusselemente für Last- und Hilfskontakte vorgesehen sind, und mit einem Gehäuse, das die zweite Hauptfläche des plättchenförmigen Substrates überdeckt, wobei das plättchenförmige Substrat mit einem zentralen ersten Loch und das Gehäuse mit einem zentralen zweiten Loch ausgebildet ist, die miteinander axial fluchten und die zum Durchstecken eines Befestigungselementes vorgesehen sind, das Gehäuse eine Deckfläche und eine umlaufende Wand aufweist, und die Deckfläche mit einem das zweite zentrale Loch begrenzenden Hülsenabschnitt ausgebildet ist, der an der zweiten Hauptfläche des Substrates anliegt.

Derartige Leistungshalbleitermodule sind im Firmenprospekt der Anmelderin "Semikron innovation + service; Partners in Power, 11238850 E 06.2000 (TH 094-000367) als Power Modules "SEMITOP 1", "SEMITOP 2", "SEMITOP 3" oder im Prospekt der Anmelderin "Semikron innovation + service, IGBT, 1123 75070 E 06.99 (TH 094-990306) auf Seite 9 als "SEMITOP ", "SEMITOP 2" und "SEMITOP 3" beschrieben. (siehe XP-2432753)

Halbleitermodule des Typs "SEMITOP 3" besitzen als elektrische Parameter z.B. bei einer Nennspannung von 1200V eine Nennstromstärke von 35A (bei einer Betriebstemperatur von 80°C) bzw. bei einer Nennspannung von 600V eine Nennstromstärke von 45A (bei der gleichen Betriebstemperatur von 80°C).

Aus der EP 0 205 746 A2 ist ein Leistungshalbleitermodul mit einem Kühlkörper und mit einem großflächigen Keramiksubstrat als Bodenfläche bekannt, wobei eine dauerhaft wirksame keramische Abstützung des Substrats gegen das Gehäuse einen dauerhaft guten thermischen Kontakt zwischen dem Substrat und dem Kühlkörper gewährleistet und vorzugsweise diese Abstützungen durch entsprechend zugeordnete Rippen am Gehäuse fixiert und stabilisiert werden.

Der Erfindung liegt die Aufgabe zugrunde, ein Leistungshalbleitermodul der oben genannten Art zu schaffen, das eine weiter erhöhte Energiedichte, d.h. bei einer entsprechenden Nennspannung eine größere Nennstromstärke besitzt, und dabei einfach ausgebildet ist.

Diese Aufgabe wird bei einem Leistungshalbleitermodul der eingangs genannten Art erfindungsgemäß durch die Merkmale des unabhängigen Anspruch 1 gelöst.

Das erfindungsgemäße Leistungshalbleitermodul weist z.B. bei einer Nennspannung von 1200V eine Nennstromstärke von 75A (bei einer Betriebstemperatur von 80°C) bzw. bei einer Nennspannung von 600V eine Nennstromstärke von z.B. 110A (bei 80°C Betriebstemperatur) auf. Daraus ergibt sich, dass die Leistung des erfindungsgemäßen Leistungshalbleitermoduls im Vergleich zu einem bekannten Leistungshalbleitermodul des Typs SEMITOP 3 mehr als verdoppelt ist. Diese Vergrößerung der Nennleistung des erfindungsgemäßen Leistungshalbleitermoduls geht zwar mit einer Vergrößerung der Grundflächenabmessungen des plättchenförmigen Substrates und des Gehäuses und somit des erfindungsgemäßen Leistungshalbleitermoduls einher. Die Energiedichte d.h. die Nennleistung bezogen auf die Grundfläche des Leistungshalbleitermoduls ist jedoch um größenordnungsmäßig 20% erhöht.

Bei dem erfindungsgemäßen Leistungshalbleitermodul hat es sich als zweckmäßig erwiesen, wenn das plättchenförmige Substrat eine mindestens annähernd quadratische Grundfläche und das Gehäuse daran angepasste Grundflächenabmessungen aufweist.

Die Versteifung ist in vorteilhafter Weise durch Rippen gebildet, die sich von dem das zentrale zweite Loch des Gehäuses begrenzenden Hülsenabschnitt radial wegerstrecken. Diese Versteifungsrippen sind zumindest an der Außenseite der Deckfläche des Gehäuses ausgebildet. Desgleichen ist es beispielsweise möglich, die Versteifungsrippen an der Außen- und an der Innenseite der Deckfläche des Gehäuses - oder im Bedarfsfall nur an der Innenseite der Deckfläche des Gehäuses auszubilden.

Bei dem erfindungsgemäßen Leistungshalbleitermodul sind die die Versteifung bildenden Rippen in Umfangsrichtung des das zentrale zweite Loch begrenzenden Hülsenabschnittes des Gehäuses vorzugsweise gleichmäßig verteilt ausgebildet, um im Gehäuse gleichmäßige Kräfteverhältnisse zu realisieren.

Bei einer bevorzugten Ausbildung des erfindungsgemäßen Leistungshalbleitermoduls erstrecken sich die Rippen von einem ringförmigen Bund des das zweite zentrale Loch begrenzenden Hülsenabschnittes weg, welcher aus der Deckfläche vorsteht.

Die Deckfläche des Gehäuses ist vorzugsweise mit Durchgangslöchern ausgebildet, durch die sich die Anschlusselemente für die Last- und Hilfsanschlüsse aus dem Gehäuse des Leistungshalbleitermoduls heraus erstrecken und mit einer Leiterplatte kontaktierbar sind.

Der durch das plättchenförmige Substrat und das Gehäuse umschlossene Innenraum ist zweckmäßigerweise größtenteils mit einem erstarrenden bzw. erstarrten Isoliermaterial gefüllt. Bei diese Isoliermaterial handelt es sich beispielsweise um eine Vergussmasse.

Weitere Einzelheiten, Merkmale und Vorteile ergeben sich aus der nachfolgenden Beschreibung eines in der Zeichnung stark vergrößert und nicht maßstabgetreu gezeichneten Ausführungsbeispiels des erfindungsgemäßen Leistungshalbleitermoduls.

Es zeigen:
- Figur 1: eine Ausbildung des Halbleitermoduls in einer Längsschnittdarstellung - in Kombination mit einem abschnittweise angedeuteten Kühlkörper und einer abschnittweise angedeuteten Leiterplatte sowie einem Befestigungselement zum Befestigen des Leistungshalbleitermoduls am Kühlkörper -, wobei das Leistungshalbleitermodul, der Kühlkörper und die Leiterplatte sowie das Befestigungselement voneinander getrennt dargestellt sind, und
- Figur 2: eine Ansicht des Leistungshalbleitermoduls in Blickrichtung der Pfeile II - II in Figur 1.

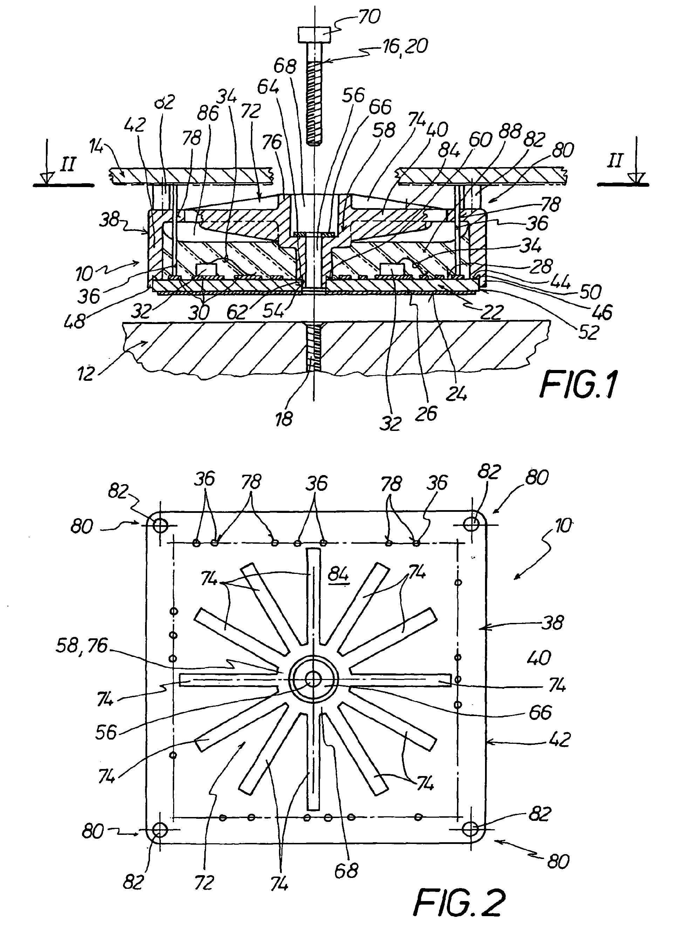

Figur 1 zeigt längsgeschnitten eine Ausbildung des Leistungshalbleitermoduls 10 und abschnittweise in einer Längsschnittdarstellung einen Kühlkörper 12 und eine Leiterplatte 14 sowie ein Befestigungselement 16 zum Befestigen des Leistungshalbleitermoduls 10 am Kühlkörper 12. Zu diesem Zwecke ist der Kühlkörper 12 mit einer Gewindebohrung 18 ausgebildet, in die das von einer Schraube 20 gebildete Befestigungselement 16 einschraubbar ist.

Das Leistungshalbleitermodul weist ein plättchenförmiges Substrat 22 auf, das aus einem Oxidkeramikmaterial besteht. Das plättchenförmige Substrat 22 weist auf seiner ersten Hauptfläche 24 eine wärmeableitende Schicht 26 auf und ist auf der gegenüberliegenden zweiten Hauptfläche 28 mit einer Leiterbahnstruktur 30 ausgebildet. Bei der wärmeableitenden Schicht 26 und bei der Leiterbahnstruktur 30 handelt es sich beispielsweise um Kupferschichten bzw. dünne Kupferfolien, die mit dem plättchenförmigen Substrat 22 fest verbunden sind.

An der Leiterbahnstruktur 30 sind Leistungshalbleiterbauelemente 32 vorgesehen, d.h. die Leiterbahnstruktur 30 dient zur Verschaltung der Leistungshalbleiterbauelemente 32. Diese Verschaltung erfolgt beispielsweise durch Bonddrähte 34.

An der Leiterbahnstruktur 30 sind außerdem Anschlusselemente 36 für Last- und Hilfskontakte vorgesehen, die mit der Leiterplatte 14 kontaktierbar sind bzw. mit dieser kontaktiert werden.

Das Leistungshalbleitermodul 10 weist ein Gehäuse 38 auf, das die zweite Hauptfläche 28 des plättchenförmigen Substrates überdeckt. Das Gehäuse 38 weist eine Deckfläche 40 und eine umlaufende Wand 42 auf. Die umlaufende Wand 42 weist eine umlaufende Anlagegrundfläche 44 auf, die am umlaufenden Randabschnitt 46 der zweiten Hauptfläche 28 des Substrates 22 im zusammengebauten Zustand des Leistungshalbleitermoduls 10 eng anliegt. Die umlaufende Anlagegrundfläche 44 der umlaufenden Wand 42 des Gehäuses 38 ist von einem umlaufenden Kragen 48 der Wand 42 durch eine umlaufende Rinne 50 beabstandet, die in der Wand 42 des Gehäuses 38 ausgebildet ist. Der umlaufende Kragen 48 liegt am Außenrand 52 des plättchenförmigen Substrates 22 an.

Das plättchenförmige Substrat 22 ist mit einem zentralen ersten Loch 54 ausgebildet.

Das Gehäuse 38 ist mit einem zentralen zweiten Loch 56 ausgebildet. Das zentrale zweite Loch 56 ist durch einen abgestuften Hülsenabschnitt 58 begrenzt, der von der Deckfläche 40 wegsteht und der mit einer ringförmigen Anlagegrundfläche 60 eng an der zweiten Hauptfläche 28 des plättchenförmigen Substrates 22 anliegt. Mit einem ringförmigen Einsteckabschnitt 62 steht der abgestufte Hülsenabschnitt 58 in das zentrale erste Loch 54 des Substrates 22 hinein. Der ringförmige Einstiegabschnitt 62 ist von der ringförmigen Anlagegrundfläche 60 durch eine umlaufende Rille 64 beabstandet, die in dem abgestuften Hülsenabschnitt 58 ausgebildet ist.

Mit der Bezugsziffer 66 ist ein Ringelement bezeichnet, das in der oberseitigen Erweiterung 68 des zentralen zweiten Loches des Gehäuses 38 für den Kopf 70 der Schraube 20 vorgesehen ist.

Die Deckfläche 40 des Gehäuses 38 ist zwischen dem Hülsenabschnitt 58 und der umlaufenden Wand 42 des Gehäuses 38 mit einer mechanischen Versteifung 72 ausgebildet. Die mechanische Versteifung 72 ist durch Rippen 74 gebildet, die sich von dem oberseitigen Endabschnitt 76 des abgestuften Hülsenabschnittes 58 radial und in Umfangsrichtung gleichmäßig beabstandet wegerstrecken, wie aus Figur 2 ersichtlich ist, in der gleiche Einzelheiten mit denselben Bezugsziffern wie in Figur 1 bezeichnet sind. Der oberseitige Endabschnitt 76 bildet einen ringförmigen Bund des abgestuften Hülsenabschnittes 58.

Das plättchenförmige Substrat 22 besitzt eine mindestens annähernd quadratische Grundfläche und das Gehäuse 38 besitzt daran angepasste Grundflächenabmessungen. Die Deckfläche 40 des Gehäuses 38 ist mit Durchgangslöchern 78 ausgebildet, durch die sich die Anschlusselemente 36 für die Last- und Hilfsanschlüsse aus dem Gehäuse 38 heraus erstrecken.

Das Gehäuse 38 ist in seinen vier Ecken 80 (siehe Figur 2) jeweils mit einem sockelförmigen Abstandselement 82 für die Leiterplatte 14 ausgebildet.

Der Bund 76 steht über die Außenseite 84 der Deckfläche 40 des Gehäuses 38 über.

In dem durch das plättchenförmige Substrat 22 und das Gehäuse 38 umschlossenen Innenraum 86 befindet sich ein Isoliermaterial 88. Bei dem Isoliermaterial 88 handelt es sich um eine elektrisch isolierende Vergussmasse, mittels welcher der Deckel 38 mit dem plättchenförmigen Substrat 22 zum Leistungshalbleitermodul 10 mechanisch fest und abdichtend verbunden ist.

### Bezugsziffernliste:

- 10: Leistungshalbleitermodul
- 12: Kühlkörper (für 10)
- 14: Leiterplatte
- 16: Befestigungselement (für 10 an 12)
- 18: Gewindebohrung (in 12)
- 20: Schraube (von 16)
- 22: plättchenförmiges Substrat (von 10)
- 24: erste Hauptfläche (von 22)
- 26: wärmeableitende Schicht (an 24)
- 28: zweite Hauptfläche (von 22)
- 30: Leiterbahnstruktur (an 28)
- 32: Leitungshalbleiterbauelemente (an 30)
- 34: Bonddrähte (zwischen 32 und 30)
- 36: Anschlusselemente (an 30 für 14)
- 38: Gehäuse (von 10)
- 40: Deckfläche (von 38)
- 42: umlaufende Wand (von 38)
- 44: umlaufende Anlagegrundfläche (von 42)
- 46: umlaufender Randabschnitt (von 22 bzw. 28)
- 48: umlaufender Kragen (von 42 an 52)
- 50: umlaufende Rinne (zwischen 48 und 44)
- 52: Außenrand (von 22)
- 54: zentrales erstes Loch (in 22)
- 56: zentrales zweites Loch (von 38)
- 58: abgestufter Hülsenabschnitt (von 38)
- 60: Anlagegrundfläche (von 58)
- 62: ringförmiger Einsteckabschnitt (von 58)
- 64: umlaufende Rille (zwischen 62 und 60)
- 66: Ringelement (in 68)
- 68: oberseitige Erweiterung (von 56)
- 70: Kopf (von 20)
- 72: mechanische Versteifung (von 38 an 40)
- 74: Rippen (von 72)
- 76: oberseitiger Endabschnitt bzw. Bund (von 58)
- 78: Durchgangslöcher (in 40 für 36)
- 80: Ecken (von 38 bzw. 40)
- 82: Abstandselemente (bei 80 für 14)
- 84: Außenseite (von 40)

## Patentansprüche

1. Leistungshalbleitermodul, mit einem plättchenförmigen Substrat (22), das auf einer ersten Hauptfläche (24) eine wärmeableitende Schicht (26) aufweist und das auf der gegenüberliegenden zweiten Hauptfläche (28) mit einer Leiterbahnstruktur (30) ausgebildet ist, an der Leistungshalbleiterbauelemente (32) und Anschlusselemente (36) für Last- und Hilfskontakte vorgesehen sind, und mit einem Gehäuse (38), das die zweite Hauptfläche (28) des plättchenförmigen Substrates (22) überdeckt, wobei das plättchenförmige Substrat (22) mit einem zentralen ersten Loch (54) und das Gehäuse (38) mit einem zentralen zweiten Loch (56) ausgebildet ist, die miteinander axial fluchten und die zum Durchstecken eines Befestigungselementes (16) vorgesehen sind, das Gehäuse (38) eine Deckfläche (40) und eine umlaufende Wand (42) aufweist, und die Deckfläche (40) mit einem das zentrale zweite Loch (56) begrenzenden Hülsenabschnitt (58) ausgebildet ist, der an der zweiten Hauptfläche (28) des Substrates (22) anliegt,
**dadurch gekennzeichnet,**
**dass** die Deckfläche (40) des Gehäuses (38) zwischen dem das zentrale zweite Durchgangsloch (56) des Gehäuses (38) begrenzenden Hülsenabschnitt (58) und der umlaufenden Wand (42) des Gehäuses (38) mit einer mechanischen Versteifung (72) ausgebildet ist und
**dass** die Versteifung (72) durch Rippen (74) gebildet ist, die sich von dem das zentrale zweite Loch (56) begrenzenden Hülsenabschnitt (58) radial wegerstrecken.

2. Leistungshalbleitermodul nach Anspruch 1,
**dadurch gekennzeichnet,**
**dass** das plättchenförmige Substrat (22) eine mindestens annähernd quadratische Grundfläche und das Gehäuse (38) daran angepasste Grundflächenabmessungen aufweist.

3. Leistungshalbleitermodul nach Anspruch 3,
**dadurch gekennzeichnet,**
**dass** die Rippen (74) zumindest an der Außenseite (84) der Deckfläche (40) des Gehäuses (38) ausgebildet sind.

4. Leistungshalbleitermodul nach Anspruch 3,
**dadurch gekennzeichnet,**
**dass** die Rippen (74) in Umfangsrichtung des das zentrale zweite Loch (56) begrenzenden Hülsenabschnittes (58) gleichmäßig verteilt ausgebildet sind.

5. Leistungshalbleitermodul nach Anspruch 5,
**dadurch gekennzeichnet,**
**dass** die Rippen (74) sich von einem ringförmigen, aus der Deckfläche (40) vorstehenden Bund (76) des das zentrale zweite Loch (56) begrenzenden Hülsenabschnittes (58) wegerstrecken.

6. Leistungshalbleitermodul nach Anspruch 1,
**dadurch gekennzeichnet,**
**dass** die Deckfläche (40) des Gehäuses (38) mit Durchgangslöchern (78) ausgebildet ist, durch die sich die Anschlusselemente (36) für die Last- und Hilfsanschlüsse aus dem Gehäuse (38) heraus erstrecken.

7. Leistungshalbleitermodul nach einem der vorhergehenden Ansprüche,
**dadurch gekennzeichnet,**
**dass** der durch das plättchenförmige Substrat (22) und das Gehäuse (38) umschlossene Innenraum (86) zumindest teilweise mit einem Isoliermaterial (88) gefüllt ist.

## Claims

1. A power semiconductor module, with a platelet-shaped substrate (22), which on a first prime surface (24) has a heat dissipating layer (26), and which on the opposing second prime surface (28) is designed with a conducting track structure (30), on which are provided power semiconductor components (32) and connecting elements (36) for load and auxiliary contacts, and with a housing (38), which covers the second prime surface (28) of the platelet-shaped substrate (22), wherein the platelet-shaped substrate (22) is designed with a central first hole (54) and the housing (38) is designed with a central second hole (56), which holes are axially aligned with one another, and which are provided for inserting through them a securing element (16), the housing (38) has a cover surface (40) and a surrounding wall (42), and the cover surface (40) is designed with a sleeve section (58) bounding the central second hole (56), which section abuts against the second prime surface (28) of the substrate (22),
**characterised in that**
the cover surface (40) of the housing (38) is designed with mechanical stiffening (72) between the sleeve section (58) bounding the central second clearance hole (56) of the housing (38) and the surrounding wall (42) of the housing (38), and **in that** the stiffening (72) is formed by ribs (74) that extend radially outwards from the sleeve section (58) bounding the central second hole (56).

2. The power semiconductor module according to Claim 1,
**characterised in**
**that** the platelet-shaped substrate (22) has an at least approximately square base surface, and
in that the housing (38) has base surface dimensions matched to those of the substrate.

3. The power semiconductor module according to Claim 2,
**characterised in**
**that** the ribs (74) are designed at least on the external side (84) of the cover surface (40) of the housing (38).

4. The power semiconductor module according to Claim 3,
**characterised in**
**that** the ribs (74) are designed to be evenly distributed in the circumferential direction of the sleeve section (58) bounding the central second hole (56) .

5. The power semiconductor module according to Claim 4,
**characterised in**
**that** the ribs (74) extend outward from a ring-shaped collar (76), projecting from the cover surface (40), of the sleeve section (58) bounding the central second hole (56).

6. The power semiconductor module according to Claim 1,
**characterised in**
**that** the cover surface (40) of the housing (38) is designed with clearance holes (78), through which the connecting elements (36), for the load and auxiliary connections, extend outwards from the housing (38).

7. The power semiconductor module according to one of the previous claims,
**characterised in**
**that** the interior space (86), surrounded by the platelet-shaped substrate (22), and the housing (38), is at least partially filled with an insulation material (88).

## Revendications

1. Module semi-conducteur de puissance, avec un substrat en forme de plaquette (22), qui comporte une couche de dissipation de chaleur (26) sur une première surface principale (24) et qui est conçu avec une structure de pistes conductrices (30) sur la deuxième surface principale (28) opposée, des composants semi-conducteurs de puissance (32) et des éléments de connexion (36) pour des contacts de charge et auxiliaires étant prévus sur la structure de pistes conductrices, et avec un boîtier (38), qui recouvre la deuxième surface principale (28) du substrat en forme de plaquette (22), le substrat en forme de plaquette (22) étant conçu avec un premier trou central (54) et le boîtier (38) étant conçu avec un deuxième trou central (56) qui sont alignés axialement l'un sur l'autre et qui sont prévus pour le passage d'un élément de fixation (16), le boîtier (38) comportant une surface de couverture (40) et une paroi circonférentielle (42), et la surface de couverture (40) étant conçue avec un tronçon de manchon (58) qui limite le deuxième trou central (56) et qui est adjacent à la deuxième surface principale (28) du substrat (22),
**caractérisé par le fait que**
la surface de couverture (40) du boîtier (38), entre le tronçon de manchon (58) limitant le deuxième trou traversant central (56) du boîtier (38) et la paroi circonférentielle (42) du boîtier (38), est conçue avec un renfort mécanique (72), et
le renfort (72) est formé par des cannelures (74) qui s'étendent radialement en s'éloignant du tronçon de manchon (58) limitant le deuxième trou central (56).

2. Module semi-conducteur de puissance selon la revendication 1,
**caractérisé par le fait que**
le substrat en forme de plaquette (22) a une surface de base au moins approximativement carrée et le boîtier (38) a des dimensions de surface de base adaptées à cette caractéristique.

3. Module semi-conducteur de puissance selon la revendication 3,
**caractérisé par le fait que**
les cannelures (74) sont conçues au moins sur le côté extérieur (84) de la surface de couverture (40) du boîtier (38).

4. Module semi-conducteur de puissance selon la revendication 3,
**caractérisé par le fait que**
les cannelures (74) sont conçues réparties uniformément dans la direction circonférentielle du tronçon de manchon (58) limitant le deuxième trou central (56).

5. Module semi-conducteur de puissance selon la revendication 5,
**caractérisé par le fait que**
les cannelures (74) s'étendent de manière à s'éloigner d'un collet annulaire (76), dépassant de la surface de couverture (40), du tronçon de manchon (58) limitant le deuxième trou central (56).

6. Module semi-conducteur de puissance selon la revendication 1,
**caractérisé par le fait que**
la surface de couverture (40) du boîtier (38) est conçue avec des trous traversants (78) à travers lesquels les éléments de connexion (36) pour les connexions de charge et auxiliaires s'étendent hors du boîtier (38).

7. Module semi-conducteur de puissance selon l'une des revendications précédentes,
**caractérisé par le fait que**
l'espace intérieur (86) entouré par le substrat en forme de plaquette (22) et par le boîtier (38) est rempli au moins partiellement d'un matériau isolant (88).
